# EUROPEAN PATENT SPECIFICATION

(11) **EP 4 030 172 B1**
(45) Date of publication and mention of the grant of the patent: **21.02.2024**
(21) Application number: 20863002.0
(22) Date of filing: 10.09.2020
(51) Int. Cl.: G01R 15/14, G01R 15/18, G01R 1/04, H01H 9/02, H01H 9/16, H01H 13/62, H01H 71/02, H01H 71/04

(54) **CONNECTION, SENSING AND MEASUREMENT DEVICE FOR CONNECTION TO AN ELECTRICAL NETWORK SWITCHGEAR DEVICE**
VERBINDUNGS-, ERFASSUNGS- UND MESSEINRICHTUNG ZUM ANSCHLUSS AN EINE ELEKTRISCHE NETZSCHALTVORRICHTUNG
DISPOSITIF DE CONNEXION, DE DÉTECTION ET DE MESURE PRÉVU POUR SE CONNECTER À UN DISPOSITIF D'APPAREILLAGE DE CONNEXION DE RÉSEAU ÉLECTRIQUE

(30) Priority: 13.09.2019 ES 201930797
(43) Date of publication of application: 20.07.2022
(73) Proprietor: Smilics Technologies S.L., 08223 Terrassa (ES)
(72) Inventor: PONS GONZALEZ, Carles, 08223 TERRASSA (ES); PONS GONZALEZ, Bernat, 08223 TERRASSA (ES); CELEMÍN GONZÁLEZ, Javier, 08223 TERRASSA (ES)
(74) Representative: Ponti & Partners, S.L.P
(86) International application number: PCT/ES2020/070543
(87) International publication number: WO 2021/048459

(56) References cited:
- EP-A1- 2 772 989
- EP-B1- 2 772 989
- WO-A1-2009/139521
- WO-A1-2017/207838
- DE-A1-102011 102 978
- US-A- 4 234 863
- US-A1- 2012 038 446
- US-A1- 2012 039 061
- US-A1- 2012 256 617
- US-A1- 2012 271 579
- US-A1- 2015 293 146
- US-A1- 2018 038 893
- US-B2- 8 536 857

## Description

### Field of the invention:

The present invention relates to a compact connection, sensing and measurement device enabling connection to the electrical grid by means of its simple and quick connection to any switching device, such as a magnetothermic switch or differential switch, on-off switches, an overvoltage protector or a device similar to those listed above; wherein the connection, sensing and measurement device has the main function of collecting and/or injecting signals that are available in the electrical grid, such as voltage or current signals of the electrical grid.

The present invention also relates to a system comprising one or more connection, sensing and measurement devices that send processed output data to one or more servers, and one or more servers provided with respective databases that wirelessly receive the processed output data transmitted by the one or more connection, sensing and measurement devices.

The connection, sensing, and measurement device of the invention can be connected both to a switchgear device that is already installed in an electrical panel, as well as in new installations.

### Background of the invention

On the one hand, switchgear devices are known on the market, such as on-off switches, magnetothermal or differential switches or surge protectors, which are installed in an electrical panel of an installation, and are generally mounted side by side, usually on a standard DIN rail.

The switchgear devices have, in most cases, metallic connection points to the grid (one for each pole), which can be arranged on the top and/or on the bottom of the switchgear and which are generally located inside respective orifices or housings. Some types of measuring devices can be connected through such metal points , as explained below.

On the other hand, there exist in the market various systems or devices for measuring the electrical parameters to which the aforementioned switchgear devices are subject, that is to say, the voltage present in their terminals and the current circulating through them when the electrical grid is active, in order to know the values of said parameters at a certain time (that is to say, an instantaneous measurement) or in a continuous period (that is, a permanent measurement).

These conventional systems or devices for measuring the electrical parameters of a switchgear device that are used today are mainly ammeter clips, transformers and shunts for measuring the current, and voltmeters for measuring the value of the voltage existing at a metallic point of connection to the electrical grid corresponding to a pole.

With respect to conventional current measurement systems or devices (ammeter clips, transformers or shunts), closed-core current sensors or open-core current sensors may be used. In the case of using open-core current sensors, there is the disadvantage that it is necessary to calibrate the current measurement systems or devices before they are used, since if such prior calibration is not carried out, the reading error thereof can reach 20%. This pre-calibration operation once the current measurement device is installed (and before use) requires a certain time and a certain skill of the installer.

Other types of bulky devices that are permanently installed adjacent to the switchgear devices are also known, requiring in addition to a certain installation time for the measurement device performed by the operator during which the grid is disconnected.

Furthermore, in most of the known measuring devices, the user or installer of said measurement device must modify the electrical panel in order to be able to permanently or temporarily install them, taking into account that in many cases said electrical panels are fully filled with switchgear devices and the free space available to house said measuring devices is very limited or almost zero; this means that modifications and extensions of the electrical panel must be made, which entails a long time on the part of the installer, an extra cost for the user and a disconnection time of the electrical grid for the users of the electrical installation which said switchgear covers.

In view of the foregoing, it is clear that there is a need to provide a suitable connection, sensing and measurement device to be connected at any metallic connection point provided in a conventional grid switching device, and that said connection, sensing and measurement device allows to be connected in a removable manner, easily, quickly, in a safe way for the installer, and without cutting the power supply of the grid, and at the same time that it measures at least the values of the voltage and the current of the grid with high precision, without requiring prior calibration before use, and moreover being capable of transmitting the signals measured at said metallic connection point to an external device.

### Object of the Invention

The object of the present invention is to design a connection, sensing and measurement device that can be connected to any switchgear device, wherein the connection, sensing and measurement device is compact, easily coupled to the switchgear, and the purpose of which is connection to the electrical grid through said switchgear device to collect (i.e. sense) and/or inject signals that are available in the electrical grid, at least the voltage signal (s) and the current signal (s) of the electrical grid and additionally other signals or parameters, and wherein the accuracy of the sensed values of the current is greater than 90% (i.e. with a reading error of less than 10%), while also not requiring prior calibration before use.

Another object of this invention is that the connection, sensing and measurement device can be connected both in the switchgear devices that are already installed in an electrical panel, and in new installations, that is, that it is of universal type.

Still another object of this invention is that the connection, sensing and measurement device can be installed in a switchgear of any type with the power active, i.e. without the need to cut off the power or modify the arrangement of any switchgear of the electrical panel.

Still another object of this invention is that the connection, sensing and measurement device can be placed in the existing space just above the switchgear, with external dimensions that do not protrude, or do not do so significantly, in width or length from the external dimensions of a switchgear.

Yet another object of this invention is that the connection, sensing and measurement device can treat the obtained parameters, and optionally to obtain other parameters that can be derived from the analysis of the voltage, current and/or other parameters obtained by said electrical grid connection system; as well as being able to transmit said parameters obtained from the electrical grid or from the environment of the workplace of the switchgear device and/or treated parameters to an external device for subsequent treatment or management. By "external device" is meant any device that is powered from the grid, for example, grid parameter measuring equipment itself such as grid analyzers, grid quality analyzers, grid-powered portable measuring equipment, or any other device such as a computer, television, etc. that is to be powered from the switchgear device.

And finally, another object of this invention is a system that includes one or more connection, sensing and measurement devices wirelessly connected to one or more servers provided with respective databases, in order to store, process, analyze and/or display the processed data outgoing from each connection, sensing and measurement device.

### Description of the Invention

The main object of the present invention is the connection, sensing and measurement device defined in claim 1.

According to this main object, the invention provides a connection device, sensing and measuring of the type of which are capable of being electrically connected to one or more of the terminals, screws, metal terminals or clamps existing in an electrical grid switchgear device.

In this specification, "a switching device of the electrical grid" makes reference to a switching device already installed or one of those that are to be installed at a point of the electrical grid. An electrical switchgear is generally connected to the electrical grid on a DIN rail or the like, and by way of non-limiting example may be of the following types: on-off switches, magnetothermic or differential switches, transformers or surge protectors.

In this specificaction, "sensing signals" or "sensing" makes reference to collecting/measuring signals and measurement.

The connection, sensing and measurement device of the invention comprises the following elements:
- a housing,
- one or more connection elements extending outwardly from said housing in a connection direction "Z", wherein each of the one or more connection elements comprises a metallic or magnetic end configured to establish a removable electrical connection to a respective screw, or connection terminal, or clamp, or to any metallic point of fixation or connection of the wiring of the switchgear device, so that by means of the one or more connection elements the connection, sensing and measurement device can collect the voltage signal (s) from the electrical grid or inject it/them into the electrical grid; and
same differs from existing ones by the fact that it also comprises:
- one or more closed-core current sensors, configured to:
   (a) sense, by each sensor, the magnetic field present on a network line and/or sense the effects of the injected signals, and/or
   (b) inject the current signals circulating through the poles of the switchgear,
      wherein the one or more closed-core current sensors are disposed spaced from the one or more connecting elements, and
      wherein each of the one or more closed-core current sensors comprises a loop with its two ends protruding from the housing in the connection direction "Z", and
      wherein said one or more end pairs of the loop may take two different positions:
         i) a first installation position of the connection, sensing and measurement device in the switchgear device, wherein the one or more pairs of sensor ends are open a certain space, so that when moving the connection, sensing and measurement device in the connection direction "Z" said certain space between ends is greater than the diameter of a respective electrical cable previously installed in the switchgear device that runs in a vertical direction "Y" to pass through, and
         ii) a second working position, wherein each pair of ends of each current sensor is closed or partially closed relative to each other forming a closed or partially closed space within the loop so as to be able to house within it the respective electrical cable of the switchgear device; and
- mechanical means configured to open and close the one or more end pairs of the one or more closed-core current sensors, driving the one or more end pairs from the second closed position to the first open position, and vice versa.

According to a preferred embodiment of the mechanical means for opening and closing the one or more end pairs of the one or more closed-core current sensors, the same are configured to open and close the one or more end pairs at a time, i.e. simultaneously.

According to a first embodiment of the connection elements, they are of the "plug&play" type and extend outwards in a connection direction in the direction of the "Z" axis, wherein each fastening and connection element for a different pole of the switchgear device, is provided with a respective magnetic end configured to at the same time be fastened and electrically connected in a removable way without any mechanical connection or wiring to a respective screw, or connection terminal, or clamp, or to any metallic point of fixing or connection of the wiring of the switchgear device. Generally, these connection points of the switchgear device are located within orifices.

Preferably, according to this first embodiment of the invention, the one or more "plug&play" type magnetic connection elements are arranged extending in a connection direction "Z" from a flat support plate that is solidly attached to the housing and where the flat plate has a surface for handling and positioning and removal by the user.

Preferably, each magnetic connection element can have at least one degree of freedom in the direction of the "Z" axis -corresponding to the depth direction of the switching device-, which allows each magnetic element of the magnetic connection means to be moved axially in this "Z" direction independently, to adapt to the small variations existing in terms of the depth of the location of each screw, connection terminal, clamp or any metallic point of fixing or connection of the wiring of each switching device model, thanks to the provision of elastic means that allow such adjustment in the "Z" direction. Therefore, said adjustment in the connection "Z" direction greatly facilitates the coupling of the magnetic connection elements and therefore of the entire connection system to the front surface of a switchgear device at the time of its installation, so that when the user places the magnetic connection elements in the respective housings of the switchgear device, the physical and electrical coupling between both parts is carried out almost automatically by the magnetic attraction force of said magnetic connection elements toward the respective screws and/or connection terminals of the switchgear device.

Also optionally, the magnetic connection elements of the "plug&play" type can also have at least a degree of freedom in the "Y" direction - corresponding to the vertical direction of the switchgear device - in order to adapt perfectly to the different geometries and configurations in height of the various switchgear devices existing and installed in current electrical panels, whose configurations and external geometries may vary slightly.

These two graduations or possibility of movement along the "Z" and "Y" axes make the recommended connection system completely universal, as it can be installed automatically and with a perfect fit in any type or model of switchgear device.

According to a possible embodiment of the magnetic connection elements, same can be configured by a rear fixed portion and a mobile front portion in the axial "Z" direction with an elongated configuration such that it can be inserted perfectly into the existing housings in the switchgear devices in which the respective screws, metal terminals or jaws are arranged, and in said mobile front part by the action of an elastic element, respective magnetic elements are incorporated in the front, whose elastic force is defined so that a user by pulling outward can easily disengage the magnetic elements of the screws or connection terminals of the switchgear device, and in turn said elastic force is such that the aforementioned compact element can be attached temporarily or permanently to the screws and/or metal terminals of the switchgear device.

By way of non-limiting example, the magnetic connection elements have an elongated cylindrical body with a diameter between 4 and 7 mm.

Preferably, the magnetic element is composed of one or more magnets arranged at the front of the elongated body. The number of magnets depends mainly on the magnetothermal switch and the depth of the screws of the magnetothermal switch to be connected. By way of example, 1 to 3 magnets could be available.

The applicant has calculated through extensive testing and experimentation the correct sizing of the elastic force of attraction of the ferromagnetic material from which the magnet is made, so that the connection system of the invention works optimally. That is to say, a user by manually pulling outwards can disengage with some ease the magnetic element of the screw and/or metal terminal of the switchgear device, thereby releasing the connector of the switchgear device, but at the same time, said elastic force of the magnet is sufficient so that the aforementioned magnetic element can be attached temporarily or permanently to the screw and/or metal terminal of the switchgear device, without the aforementioned connector being disconnected, for example by the action of the force of gravity, some time after its installation. Moreover, this elastic force of attraction of the ferromagnetic material is also calculated to allow obtaining correct signals from the electrical grid (i.e. without inaccuracies or distortions). More specifically, it has been empirically determined by the applicant in different switching devices with four poles (the most common case) that the connection system has an extraction force of the order of about 5 Newtons so that the disconnection of the connection system is easy, but at the same time that the connection of the same to the switching device is sufficiently firm. This force is approximately equivalent to about 10 Newtons in case of separating it from a flat surface of ferromagnetic material. The force of attraction of the magnets to achieve these values has been determined, although it could be modified if necessary using different materials. Generally the elastic force of attraction is proportional to the number of magnets used. That is, the magnetic elements are preferably one or more magnets with an extraction force of between 5 and 10 Newtons.

The manual operation of coupling and uncoupling this device with magnetic ends at a connection point of a switchgear device is extremely simple (without requiring any tools), fast (it can be installed in less than 3 seconds) and safe (because no electrical cable needs to be handled), and can be performed by any type of user, even one who is not professional in the sector, without the need to use any type of wiring or tool.

In addition, another advantage allowed by this device is connection to an electrical switching device in a non-intrusive manner for the transmission of electrical parameters and/or power supply of devices. The fact of not being intrusive reduces the electrical risk in the process of installing equipment or measuring electrical parameters. In addition, being non-intrusive allows it to be installed without having to disconnect the electrical supply of the switchgear, which implies a great saving of time, space and costs, while also eliminating the inconvenience caused to users by the disconnection of the electrical grid during the installation process of conventional measurement systems.

This first variant of the device with magnetic ends has a universal configuration that allows it to adapt to different types of switchgear terminals, making it very versatile and suitable for multiple types of installations. In addition, it can be used interchangeably in single-phase or multiphase power systems, in different configurations and variants.

Additionally, the device may comprise internal magnetic shielding means for reducing any influence of undesired internal and/or external magnetic fields produced by the magnetic elements.

According to an option of the first embodiment of the one or more connecting elements, the housing can comprise on its rear an independent element fixed to the housing referred to as the common board, which incorporates the one or more connecting elements, which at the same time acts as a support plate, and also facilitates the operation and positioning and removal by the user of the device of the invention in the switchgear device. In addition, in the case of having a digital data display, it can be placed on said common board.

According to a second alternative embodiment of the one or more connecting elements, they extend outwardly from the housing in a vertical connection direction "Y", wherein each connecting element for a different pole of the switching device comprises a respective metal end (for example a metal plate) configured to be electrically removably connected to a metal point of attachment or connection of the wiring of the switching device arranged on the top of the switching device and wherein each metal end is tightened by a respective screw that is inserted inside each front hole of the switching device.

The connection, sensing and measurement device of the invention can be manufactured for single-phase, three-phase or polyphase power systems. In the case of the single-phase model, the connection, sensing and measurement device has a single current sensor. In the case of the three-phase model, it has three current sensors, which sense the respective currents that run through each of the three lines L1, L2 and L3. Within the three-phase model there is the three-phase model with neutral and the three-phase model without neutral, although both have three current sensors, one for each line/pole.

In the first embodiment of the magnetic ends, these are arranged at a minimum distance "A" from the one or more closed-core current sensors, in order to minimize the possible influence or interference that the magnetic field of the magnetic elements could have on the correct functioning of said sensing and/or injecting means. Several field studies carried out by the applicant have concluded that said value of the minimum distance "A" must be at least 8 mm in order for the efficiency of the connection system of the present invention to be optimal (i.e. without significant interference).

According to a first embodiment of the one or more closed-core current sensors, they are of the flexible type, that is, such that their configuration and flexible nature allow their tips/ends to be easily moved. In such case, the flexible closed-core current sensor (s) are chosen from among the following types of sensors known in the prior art: air-core, optical, Hall effect or any other type capable of integrating with this format. Preferably, one or more flexible sensors of the air-core type are chosen.

Preferably, in this first embodiment of the flexible current sensors, the parts of the current sensor(s) that are outside the interior of the housing are covered by respective sheaths of electrically insulating and flexible material, as a safety measure for the installer or user who may touch them. Said sheaths are sufficiently flexible to allow the ends of the sensors to be slightly bent between the first and second positions of the sensors. Said sheaths are preferably individual, that is, there is on sheath for each outer section of the sensor.

According to this first embodiment of the flexible current sensors, in the first working position the two ends of each sensor may be in one of the following positions:
1. one of the two ends of each sensor is touching the other end, or
2. one of the two ends of each sensor is crossed with respect to each other (such that the loop of each sensor is completed), or
3. one of the two ends of each sensor is close to the other end, but without touching or crossing.

In the case of choosing an air-core sensor, preferably, the two ends of each sensor remain in the position where they are crossed with respect to each other (i.e. position 2). In this position 2 it has been found that the accuracy of the sensors is the most optimal out of the 3 positions.

According to a second embodiment of the one or more closed-core current sensors, same are of the rigid type. In this case, the one or more rigid closed-core current sensors are chosen from among the following types of sensors known in the state of the art: air-core, iron-core, optical, magnetoresistive, Hall effect, zero-flow current collectors, hybrid or ultrasonic. Preferably, one or more rigid sensors of the air-core type are chosen.

With respect to the mechanical means for opening and closing the ends of the sensors from the first position to the second position, the same are configured to be preferably manually actuated by a user or operator.

According to a first embodiment of these mechanical means for opening and closing the end pairs of the one or more flexible sensors, they comprise a portion movable in the connection direction "Z" in both senses that is guided to move all the groups of two ends at the same time. Preferably, the movable part is formed by a side portion and a front portion integral with each other, wherein the front portion is provided with a hole for each tip configured so that a tip can pass through it, and comprises on said front portion guiding elements with a curved profile for each tip.

Preferably, the movable portion is guided laterally by means of guides provided in the housing for this purpose, that is, with the dimensions and configuration necessary to be able to act as a guide, for example having a "U" shaped profile in which the movable portion is imprisoned.

The holder of this invention has found that this advantageous and ingenious configuration of the movable portion works optimally to fulfill the function of simultaneously opening and closing all the end pairs of the one or more flexible sensors at once with extreme ease and with total precision (i.e. without misalignments), with only the manual displacement by the user of the movable portion up or down in the connection direction "Z". In addition, it has been tested that repeated operations of opening and closing all end pairs of the one or more flexible sensors do not spoil or impair their function and can operate effectively for a long period of time. This mobile portion has been specifically designed to fulfill this purpose without any error.

Preferably, this movable portion is made from a rigid material and has a small thickness.

In this first embodiment of the mechanical means for opening and closing the ends of the sensors, the housing comprises stops on an upper part of the lateral guides of the movable portion.

This movable portion displaceable in the connection direction "Z" has a horizontal part and a vertical part joined together, wherein the vertical part has corresponding holes for the tips to pass through. Preferably, in such holes there extend slightly curved extensions for supporting the ends of the sensors during the opening operation. In the resting position the tips of the sensors are in the closed or semi-closed position.

According to a second possible embodiment of the mechanical means for opening and closing the pairs of ends of the one or more rigid sensors, they can comprise one or more pushbuttons that move two respective lever elements, wherein each of these two lever elements displace, at the same time, the respective guides of each end. That is, a first lever element simultaneously displaces all the guides corresponding to each left end of the sensors while a second lever element simultaneously displaces all the guides corresponding to each right end of the sensors.

In particular, with reference to the housing, as indicated above, it may comprise on its back a common plate. In addition, preferably, the compact housing has a closed body that is open only at its front part for the exit of the ends of the one or more closed-core current sensors.

According to a possible configuration of the housing, same is formed by a one-piece body preferably of electrical insulating material, for example, of plastic.

According to a possible configuration of the housing, it consists of at least two different pieces that fit together and are fixed immovably. This two-piece configuration facilitates the mounting of the one or more sensors inside the housing and the subsequent closing of the two parts to form the housing body.

Optionally, additional sensing means for measuring parameters or signals other than voltage and current may be incorporated into the interior of the device housing, such as temperature, humidity, vibration and/or acceleration, presence/movement/proximity, GPS (including date, time, and place of installation), and/or lighting. Thus, the provision of presence/movement/proximity sensors allows detecting, for example, that someone approaches an electrical panel and can cause damage or undesired maneuvers, or the provision of GPS sensors allows the compact connection system to be used for example to detect or control maintenance in different locations or geographical situations.

In addition, the connection, sensing and measurement device of the invention may comprise inside the device means for processing said parameters or signals captured and/or injected of current and/or voltage and/or other parameters. These processing means of said current and/or voltage parameters or signals of and/or other parameters detected and/or injected may be configured such that they are integrated into a microprocessor and/or microcontroller chip.

These processing means may comprise the corresponding hardware and software that performs the necessary signal processing actions and/or functions of said parameters or signal processing means.

Such processing actions and/or functions or measurements obtained by said processing means for said parameters or signals may be, by way of non-limiting example, the following:
- Voltage and quality parameters of the grid related to their variation, e.g.:
   fluctuations, flicker, gaps, interruptions, transient and/or temporary overvoltages, undervoltages, phase imbalance, harmonic and interharmonic voltages; and/or
- Current through the switchgear and its harmonics; and/or
- Frequency; and/or
- Power; and/or
- Energy; and/or
- Registration of the action of protective devices such as magnetothermal and/or differential switches. With the appropriate devices, the date, time and place (GPS) at which the incident occurred can be determined; and/or
- Checking the correct operation of magnetothermal and differential switches without having to disassemble them from the switchgear panel; and/or
- Ageing of switchgear, e.g. surge protectors; and/or
- Determining grid impedance; and/or
- Temperature and/or humidity at the site where the device is installed; and/or
- Presence detection; and/or
- Detection of illumination; and/or
- Transmission and/or reception of the desired information via cable, wirelessly and/or via the electrical grid itself.

By way of example, the parameters processed by the processing means from the sensed voltage and/or current values are one or more of the following: Hz, PF, KvarC, KVA, kW, kWh, KvarLh, LvarCh.

The applications mentioned above can be carried out by a single device or by several interconnected connection devices, for example, by "master/slave" type structures or the like.

Also additionally, the connection, sensing and measurement device of the invention may comprise within it means of transmission, preferably wirelessly type, of said parameters or signals measured or processed by the processing means to an external device of management and/or storage of data, such as a PC, data networks or a local server or cloud-based server. Alternatively, these may be non-wireless means connectable via respective connection pins or the like provided in such a system for this purpose. In the case of wireless type transmission media, they are preferably chosen from the following types: GSM, wifi, bluetooth, NB-loT (Narrowband Internet of Things), Lora, SIGFOX or any other type of radio communication. The external device may carry out the desired actions in each case, for example, the management of alarms when the sensed signals exceed preset limit parameters, control and/or surveillance tasks of one or more processes, among other possible functions, by means of the corresponding software and hardware designed for this purpose.

Also in the case that the type of wireless transmission is via GSM or NB-loT, the connection, sensing and measurement device of the invention can comprise a SIM card inside the housing to be able to provide the wireless transmission of a specific connection, sensing and measurement device.

Optionally, in addition to the wireless type transmission means, the connection, sensing and measurement device of the invention may also be equipped with physical (i.e. wired) transmission means such as Ethernet, RS485, RS232, whereby the connection, sensing and measurement device of the invention is provided with the appropriate connectors for such purpose.

Also additionally, the connection, sensing and measurement device of the invention may comprise means for displaying or indicating the sensed, injected and/or processed parameters, such as for example a digital display arranged in a front exterior area of the device, so that the user can display in a preferred place of the device itself the values of the measured parameters.

Also additionally, the housing of the connection, sensing and measurement device of the invention can comprise a peripheral outer configuration and geometry designed such that the side surface of a first device matches the opposite side surface of a second contiguous device without there being a gap between the side surfaces of the two connectors, for example formed said coupling side surfaces with corresponding gaps and protrusions. Thus, the connecting, sensing and measurement device of the invention takes up even less space in the switching device.

Preferably, the device of the invention has very small outer dimensions, so that it can be installed without occupying any space in width or length, or not significantly, on the top and/or bottom of a conventional switchgear device.

However, the outer geometric shape of the recommended connection device is not limiting, in that it can be modified to make it feasible to install several contiguous measuring devices, either laterally or vertically, to adapt to the particular dimensions of a particular switchgear device or to improve the sensing and/or injection of signals.

As indicated above, the connection, sensing and measurement device of the invention can be used interchangeably in single-phase or multi-phase power systems.

A second object of the present invention defined in claim 15 is a system comprising:
- one or more of the devices defined above that send processed output data to one or more servers, and
- one or more servers, each comprising a database that receives the processed output data transmitted from one or more devices,
wherein the one or more devices and the one or more servers are wirelessly connected and communicated.

This system is formed by at least two devices that are interconnected with each other, preferably coupled laterally, where the connection system can be interconnected with other connection systems installed in switchgear devices related or interconnected with it, for example in "master/slave" type structures or the like, so that one connection, sensing and measurement device can receive signals from another or several other connection system(s) next to it or send signals, also managing said signals.

A third object of the present invention defined in claim 16 is a method, for operating the data processed by the device (10, 100) defined above, comprising carrying out the following steps:
- electrically connecting one or more devices in respective switching devices;
- registering a permitted user in one or more devices on a web platform;
- the one or more devices sensing at least the grid voltage signal(s) and the magnetic field present on a line of the grid,
- generating inside the one or more devices processed signals of at least the grid voltage signal(s) and the grid current signal(s);
- wirelessly sending the processed signals to one or more remote or local servers, each server comprising a database receiving and storing the processed output data transmitted from the one or more devices; and
- viewing of the signals stored in the database(s) by a permitted user in an loS or Android mobile application or in a computer.

In short, the device object of this invention has remarkable advantages that make it much more reliable in terms of obtaining measurements, that is user friendly, quick to install and uninstall in relation to the connection, sensing and measurement devices currently available, and fully versatile for installation in any type of existing switchgear device without the need to cut the power supply or the modification of the electrical panel where the switchgear is installed. These and other features will be better understood in view of the following detailed description, which, for ease of understanding, is accompanied by fifteen sheets of drawings which depict a practical embodiment which is cited only by way of non-limiting example of the scope of the present invention.

### Brief Description of the Drawings

In order to better understand the description made, a set of drawings has been provided which, schematically and solely by way of non-limiting example, represents two practical examples of embodiment.
Figure 1 is a front perspective view of a first embodiment of the connection, sensing and measurement device of the present invention in a position where the flexible type current sensors are in the closed position.
Figure 2 is a perspective view of the first embodiment of the connection, sensing and measurement device of the invention in the same position as figure 1 with the current sensors closed.
Figure 3 is a top plan view of the first embodiment of the connection, sensing and measurement device of the invention.
Figures 4a and 4b are respective lower plan views of the first embodiment of the connection, sensing and measurement device of the invention, where the former shows the ends of the sensors in the closed position and the second in the open position.
Figure 5 is a left side elevation view of the first embodiment of the connection, sensing and measurement device of the invention.
Figure 6 is a right side elevation view of the first embodiment of the connection, sensing and measurement device of the invention.
Figure 7 is a front elevation view of the first embodiment of the connection, sensing and measurement device of the invention.
Figure 8 is a rear elevation view of the first embodiment of the connection, sensing and measurement device of the invention.
Figure 9 is an exploded view of the first embodiment of the connection, sensing and measurement device of the invention, where all the different components are represented.
Figures 10 and 11 are respective views in two different perspectives of the assembly formed by the front support plate and the circuit boards of the first embodiment of the connection, sensing and measurement device of the invention.
Figures 12 and 13 are respectively schematic side views of the switchgear in the first embodiment with the connection, sensing and measurement device of the invention in a mounting position and in an already mounted position, respectively.
Figure 14 is a schematic view of the switchgear device seen from the front with the first embodiment of the connection, sensing and measurement device of the invention in the already mounted position.
Figure 15 is a front perspective view of a second embodiment of the connection, sensing and measurement device of the present invention in a position where the rigid type current sensors are in the closed position.
Figure 16 is a perspective view of the second embodiment of the connection, sensing and measurement device of the invention in the same position as figure 1 with the current sensors closed.
Figure 17 is a top plan view of the second embodiment of the connection, sensing and measurement device of the invention.
Figures 18a and 18b are respective lower plan views of the second embodiment of the connection, sensing and measurement device of the invention, wherein the first has the ends of the rigid sensors in the closed position and the second in the open position.
Figure 19 is a left side elevation view of the second embodiment of the connection, sensing and measurement device of the invention.
Figure 20 is a right side elevation view of the second embodiment of the connection, sensing and measurement device of the invention.
Figure 21 is a front elevation view of the second embodiment of the connection, sensing and measurement device of the invention.
Figure 22 is a rear elevation view of the second embodiment of the connection, sensing and measurement device of the invention.
Figure 23 is a perspective view of the second embodiment of the connection, sensing and measurement device of the invention, where the mechanical means are shown.
Figure 24 is a schematic view of the system of devices of the invention.
Figure 25 is a schematic block diagram of the various constituent elements of the connection, sensing and measurement device of the invention.

### Description of Some Preferred Embodiments of the Invention

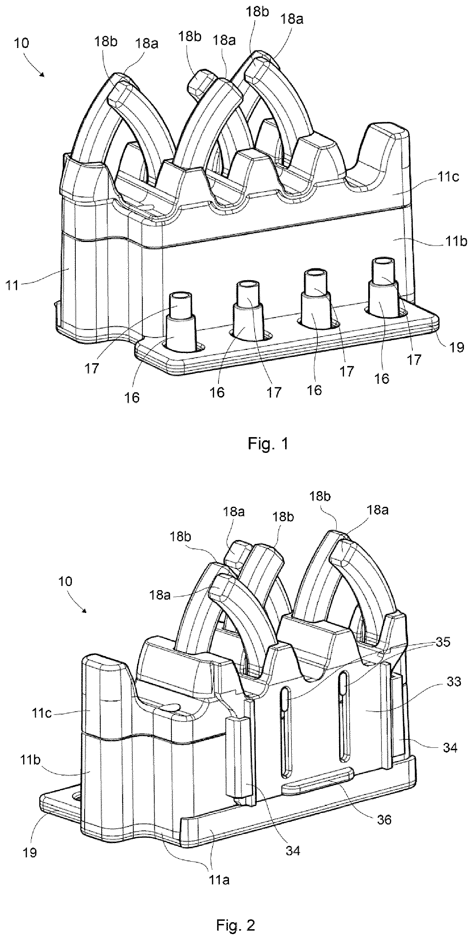

A first preferred embodiment of the connection, sensing and measurement device (10) of the invention is described below, with particular reference to the accompanying Figures 1 to 14.

In this first embodiment, the external and internal configuration of the connection, sensing, and measurement device (10) of the invention can be appreciated. Specifically, the first figures 1 to 8 show various external views of the connecting, sensing and measurement device (10).

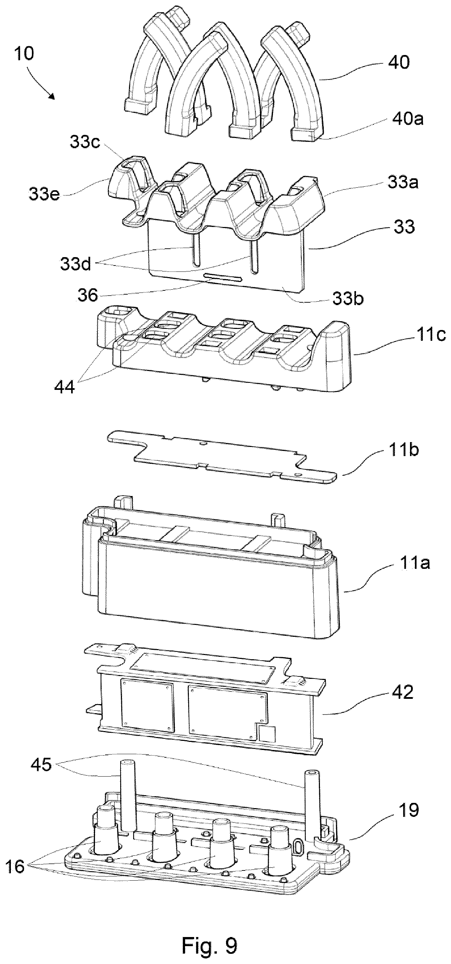

The mounted assembly of the connection, sensing and measurement device (10) is formed externally by a housing (11), in this case formed by three distinct parts (11a, 11b, 11c) joined together, and by a front support plate (19) extending below the housing (11) and incorporating one or more plug&play type connection elements (16) extending towards the connection direction "Z", see Figure 9. The casing has a substantially prismatic body on the outside whic laterally presents complementary coupling surfaces: on one side a protruding surface (27) and on the opposite side a recessed surface (28), see Figures 1, 2, 7 and 8.

In this particular case, four connection elements (16) are provided, each provided with a respective magnetic end (17) configured to be magnetically fastened and removably electrically connected to a respective screw, or connection terminal, or clamp (25), or to any metallic point for fixing or connecting the wiring of the switchgear (13).

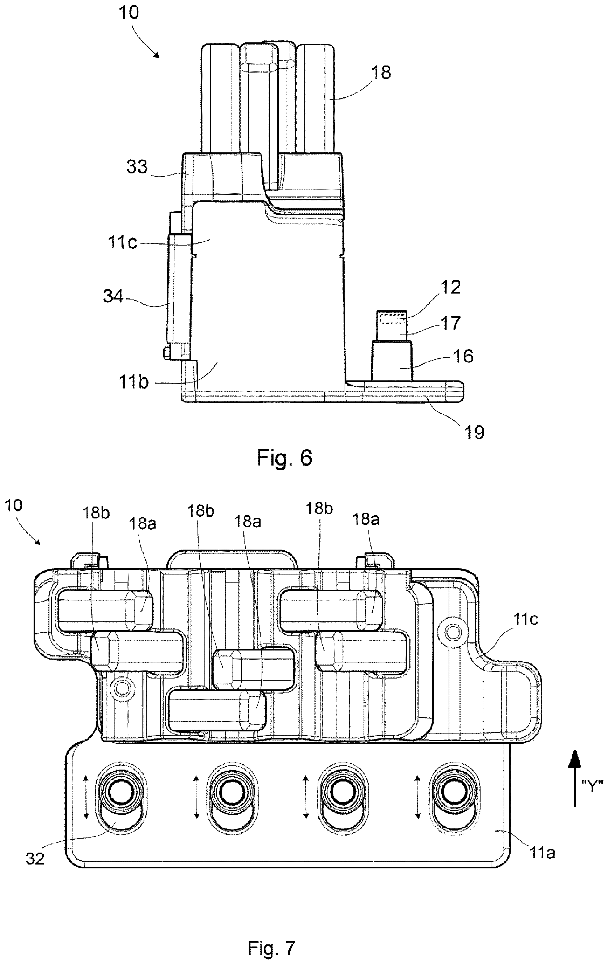

These magnetic ends (17) have a metallic cylindrical body within which one or more magnets (12) are inserted into the front of the cylindrical body, see figure 6, with a single magnet (12) drawn in a dashed line.

As seen in the accompanying figures, each connecting element (16) has a rear fixed portion (30) and a front movable portion (17) in the connection direction "Z" and whose elongated configuration is such that it can be perfectly inserted into the housings (15) existing in the switchgear devices (13). One or more magnetic elements (12) are incorporated into the front internal part of the front movable portion (17). Mobility in the "Z" axis of the aforementioned movable portion (17) is possible thanks to an elastic element (not shown in the accompanying Figures), which makes it possible to adapt the length of the connection elements (16) to the small variations present in the depth of the location of each screw, connection terminal, clamp (25) or any metallic point of attachment or connection of the wiring of each model of the switching device (13).

As can be seen in Figure 7, the four connection elements (16) can additionally have a degree of freedom in the "Y" direction - that is, in the direction corresponding to the vertical of the switching device (13)- in order to be able to move up and down on the "Y" axis and adapt perfectly to the different geometries and height configurations of the various switching devices (13).

Internally, the mounted assembly of the connection, sensing and measurement device (10) for three-phase power supply systems is formed by three flexible-type closed-core current sensors, each provided with two ends (18a, 18b) protruding from the housing (11) in the connection direction "Z", see figures 1 to 7. For single-phase systems, it would have a single closed-core current sensor.

In this particular case, these three closed-core and flexible-core current sensors are formed by air-core sensors, which are configured by coils that wind forming a flexible loop. In figure 9, the three coils which would go respectively inside each protective cover (40) have not been represented. Above the outside of said coil ends are the respective protective sheaths (40) of electrically insulating (such as plastic) and flexible material, see figure 9. Said protective sheaths (40) have a closed front end and a rear end provided with an extended part (40a) configured to be seated on the back of the through holes (44) of the housing (11c) and thus fix the protective sheaths (40) in the housing (11).

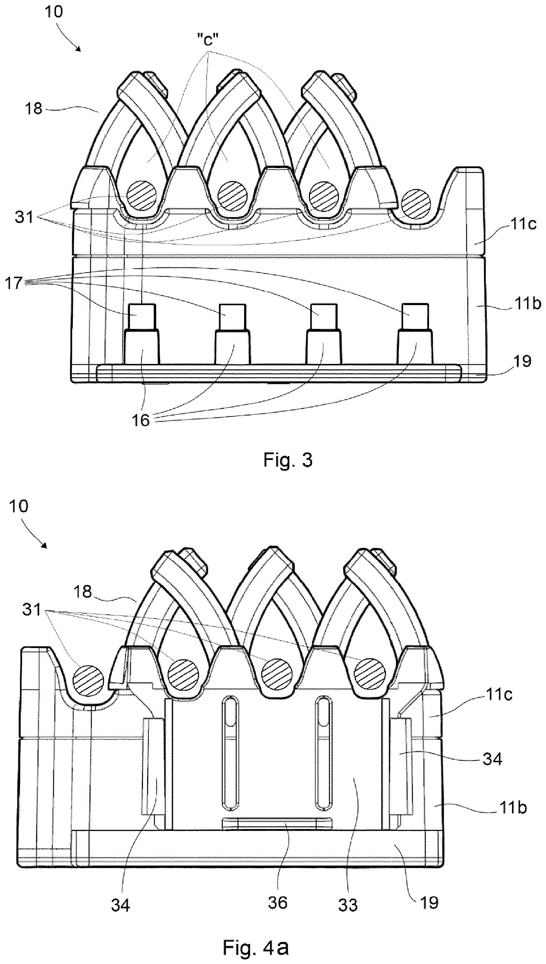

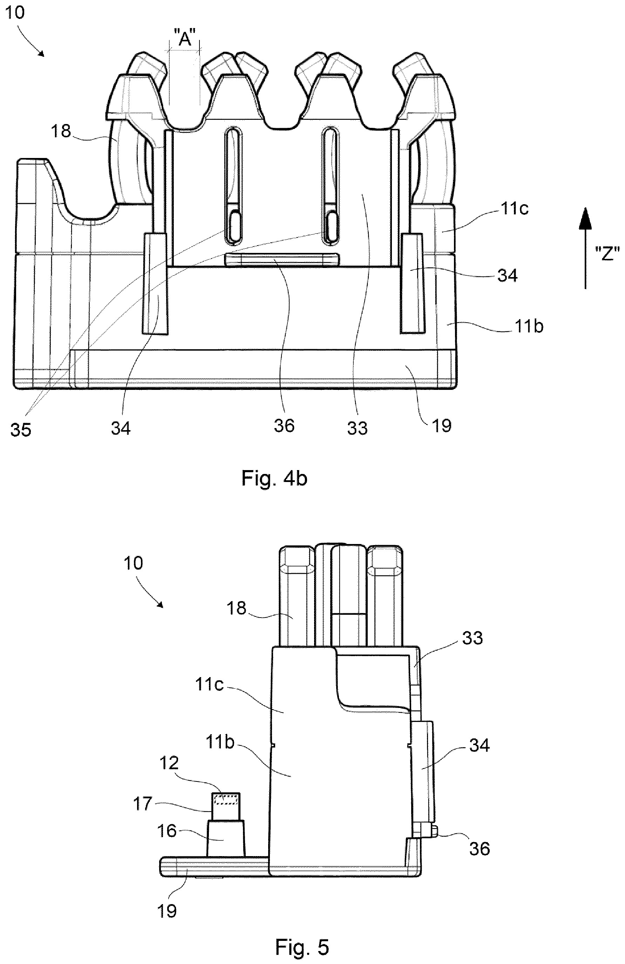

These one or more end pairs (18a, 18b) of the three closed-core current sensors may take two different positions, as shown in the accompanying figures:
i) a first installation position of the device (10) in the switchgear device (13) shown in Figure 4b: the one or more end pairs (18a, 18b) of the 3 current sensors are open a certain space "X", so that when the device (10) moves in the connection direction "Z" said certain space "A" between end pairs is greater than the diameter "B" of a respective electrical cable previously installed in the switchgear device (13) that runs in a vertical direction "Y" to pass through; and
ii) a second working position of the device (10) shown in Figure 4a: the one or more end pairs (18a, 18b) of the three current sensors are closed relative to each other forming a closed space "c" within the loop for housing the respective electrical cable (31) of the switchgear device (13) inside.

In this particular case illustrated, in the second working position the three pairs of ends (18a, 18b) are crossed with respect to each other, but in different planes, see figures 1, 2 and 7.

This change between the two positions of the sensor is driven by an opening and closing mechanism that forces the end pair(s) (18a, 18b) to move from the second closed position to the first open position, and vice versa.

The means or mechanism for opening and closing the end pair(s) (18a, 18b) is formed by a movable portion (33) which can be displaced in the connection direction "Z" in both directions and which is guided by lateral guides (34) provided in the housing (11). In this particular case, two side guides (34) are provided arranged to guide each of the side bases of the movable portion (33). Such side guides (34) can have for example an elbow-shaped section forming a longitudinal rail for guiding each side base of the movable portion (33).

This movable portion (33) acts in such a way that it opens and closes all of the one or more pairs of ends at once.

As seen in Figure 9, the movable portion (33) is formed by a side portion (33b) and a front portion (33a) integrally joined to each other and substantially perpendicular to each other, and wherein the front portion (33a) is provided with a respective through hole (33c) for each tip configured so that a tip can pass through it, and in said front portion (33a) guide elements (33e) with a curved profile are provided for each tip. In addition, the side portion (33b) has guide grooves (33d) of upper stops (43) provided in the housing (11a, 11b, 11c). In this particular case, two straight guide grooves are provided, one on each side, one for each stop (43).

With respect to the guide elements (33e), the same preferably have a portion that extends frontally from each respective through-hole (33c) for each tip to help the most extreme parts of the sensor end pairs to remain in the open position.

With respect to the front portion (33a), it has a body having a base whose shape comprises a plurality of grooves complementary to the shape of the upper portion of the housing (11c), so that the two surfaces engage each other when the device (10) is mounted.

Further, the side portion 33b may incorporate a handle 36, see Figures 2, 4a, and 4b, at its outermost portion away from the tips so that a user or installer can move the movable portion 33 up and down guided by the side guides 34.

In this particular case, see figure 9, three parts (11a, 11b, 11c) of the housing are foreseen, wherein the rear part (11a) has a substantially prismatic body with sides having complementary surfaces, in order to be able to engage two devices (10) laterally. The front portion 11c has an outer front surface complementary to the surface of the movable portion 33 and provided with holes 44 for the outlet of each end of the sensor 18. The front part (11c) also has holes for the passage of fixing elements (not shown in the attached Figures) to firmly fix the different parts (11a, 11b, 11c) of the housing and the front support plate (19). And the intermediate portion 11b is a plate for holding the back of the sensors.

With reference to the front support plate (19), the same incorporates on the inside some support elements (45) inside which a fixing element is inserted (not shown in the attached Figures). These support elements (45) are aligned with the holes for the passage of fixing elements of the front part (11c). Also on the inside, the front support plate (19) incorporates respective elongate holes (32) to guide the vertical displacement in "Y", see figure 7.

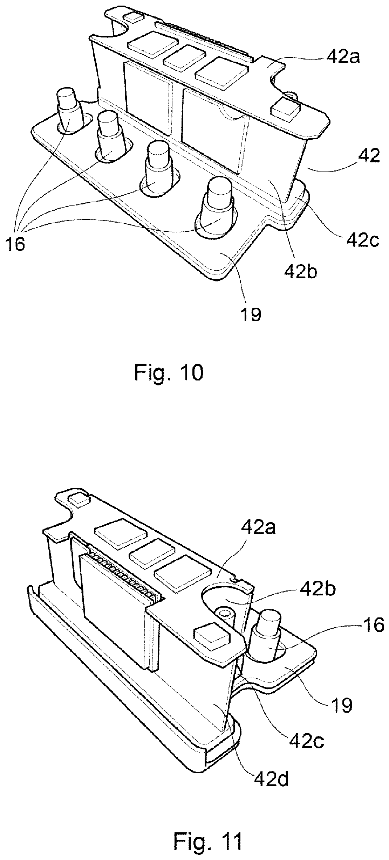

With regard to the front support plate (19), it incorporates several circuit boards (42) in charge of different functions of the device (10, 100). A possible configuration of the circuit boards (42) mounted on the inside of the front support plate (19) is shown in Figures 10 and 11. Specifically, a power supply board (42b) of the device (10) is provided, whose function is to convert the input voltage from 230VdC to 5VdC and 3.3VdC to power the different mechanisms of the device (10). A current measuring board (42a) is also provided, the function of which is to deliver the signal from the sensors and also to adapt (e.g., amplify, filter, etc.) the signals received from the sensor and send them to the microcontroller to deliver the measurement. A communications board (42d) incorporating a microchip is also provided. Said microchip may be suitable for transmitting the signals of the device (10) via one of the following types of communication: GSM, wifi, bluetooth, NB-loT (Narrowband Internet of Things), Lora, SIGFOX or any other type of radio communication. Also provided is a voltage measurement and control and indication board (42c), the function of which to measure the voltage from the readings of the connection elements (16).

Preferably, these boards (42a, 42b, 42c, 42d) are of the printed circuit type, and have the dimensions and shapes necessary to be perfectly inserted in the inner cavity formed inside the housing (11). These four plates (42a, 42b, 42c, 42d) can be arranged in other locations without affecting the functionality of the invention.

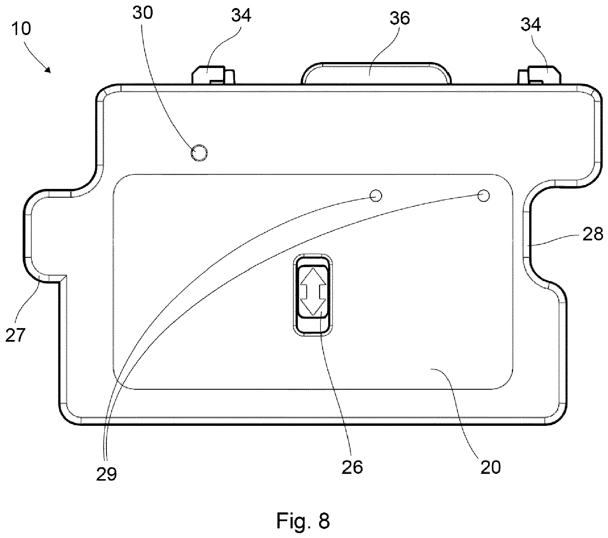

In this particular case the front support plate (19), which corresponds to the plate opposite to where the integrated circuit boards (42a, 42b, 42c, 42d) are located, is provided on its visible face with some light indicators, for example of the led type (29). Figure 8 shows, by way of example, a red LED for indicating the operation of the device (10) and a blue LED for indicating the status of the wireless communications of the device (10). In addition to these two light indicators (29), the plate has a display (20) and a "reset" button (30). A button (26) is also provided for manually actuating the connection elements (16) up and down in the direction of the "Y" axis.

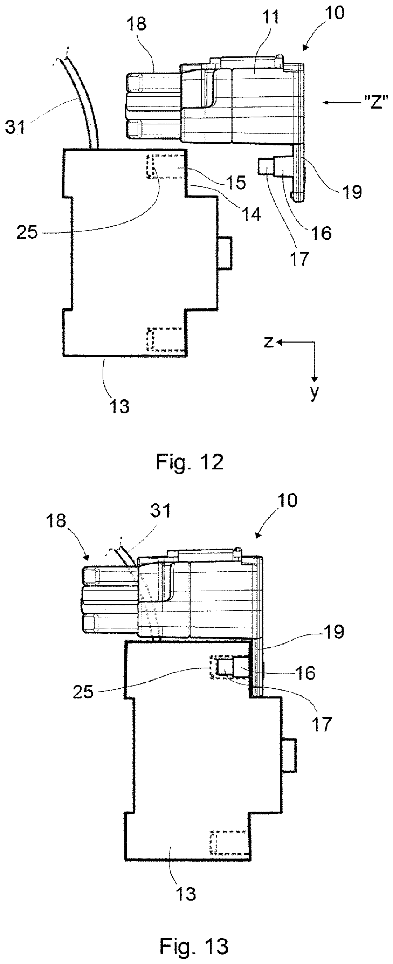

The connection, sensing, and measurement device (10) of this first embodiment of the invention is configured so that it can be electrically connected to one or more of the screws, connection terminals, or clamps of a grid switching device (13). Figures 12 to 14 show respective views of how a connection, sensing, and measurement device (10) is connected to a grid switching device (13). In said figures 12 to 14 it is seen how the device (10) is connected through the different connection elements (16, 17) to respective metal parts (25) provided inside the respective connection holes (15) arranged on the top of the front face (14) of the grid switching device (13). Once the magnetic tips (17) make contact with the respective metal parts (25) they are perfectly fastened and electrically connected to each other, as shown in figure 13. The connecting elements (16, 17) have a shape and size such that they can be optimally inserted in the connecting holes (15) of the top of the front face of the grid switching device (13). Once the connecting elements (16, 17) are also fastened, the cables (31) of the switching device (13) are housed within the respective closed or semi-closed loops of each sensor (18).

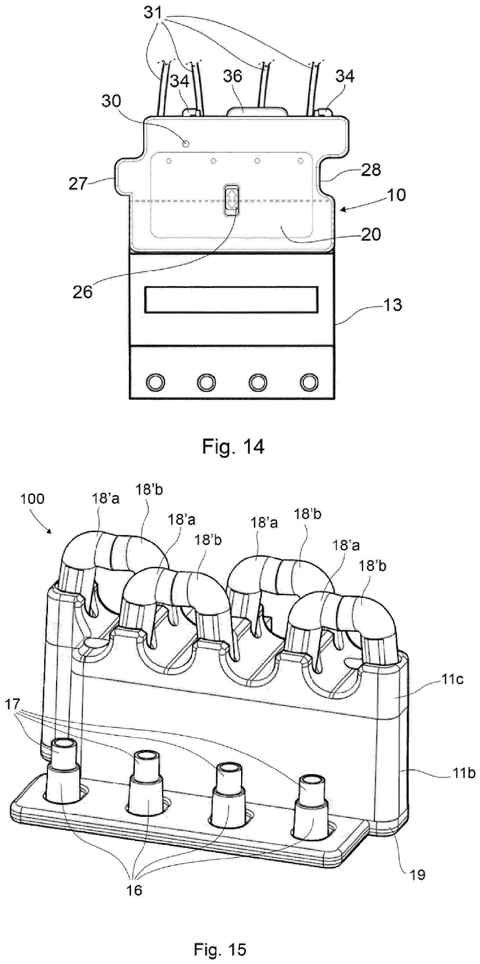

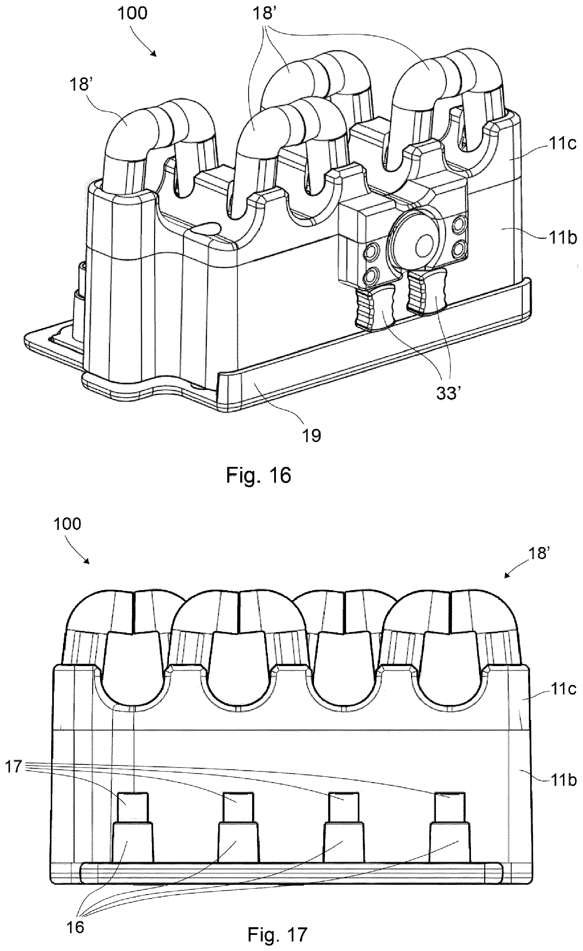

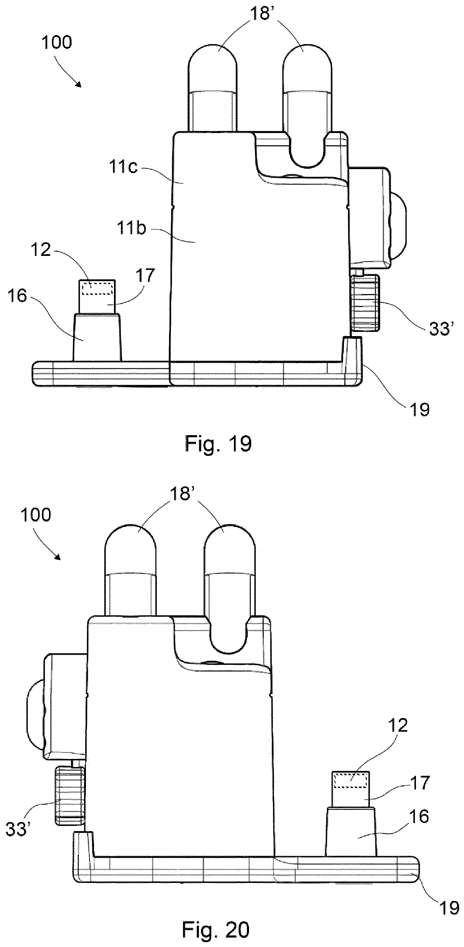

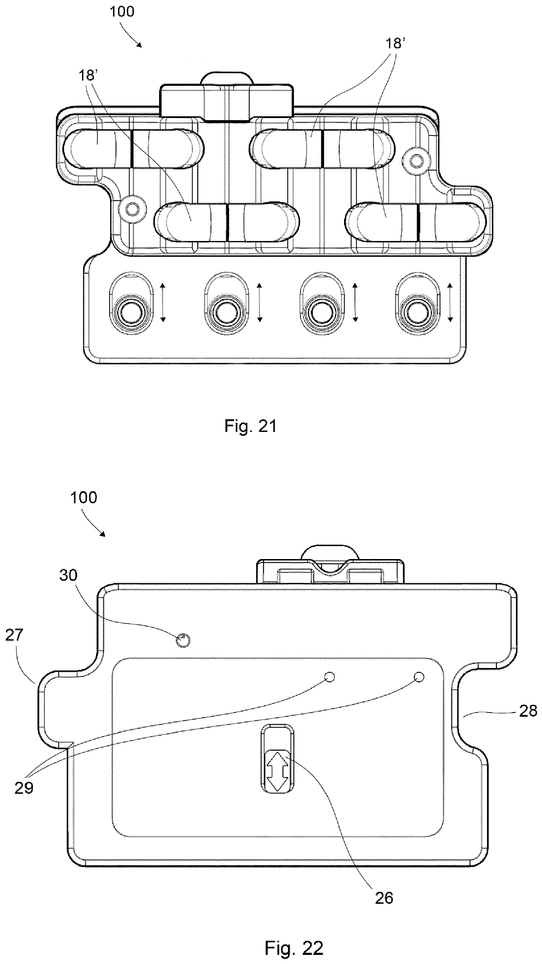

A preferred embodiment of the connection, sensing and measurement device (100) is described below with reference to figures 15 to 23.

This second preferred embodiment of the connection, sensing, and measurement device 100 has one or more rigid-type closed-core current sensors (18'). Most of the components of the device (100) are similar to those of the first preferred embodiment of the connection, sensing and measurement device (10) described above, with the exception of the sensors which are of the rigid type and also the mechanical means for opening and closing the end pairs of the one or more rigid sensors (18'). It also has a closed housing that is topped at the back by the support plate (19) from where the one or more connection elements (16, 17) extend in the connection direction "Z".

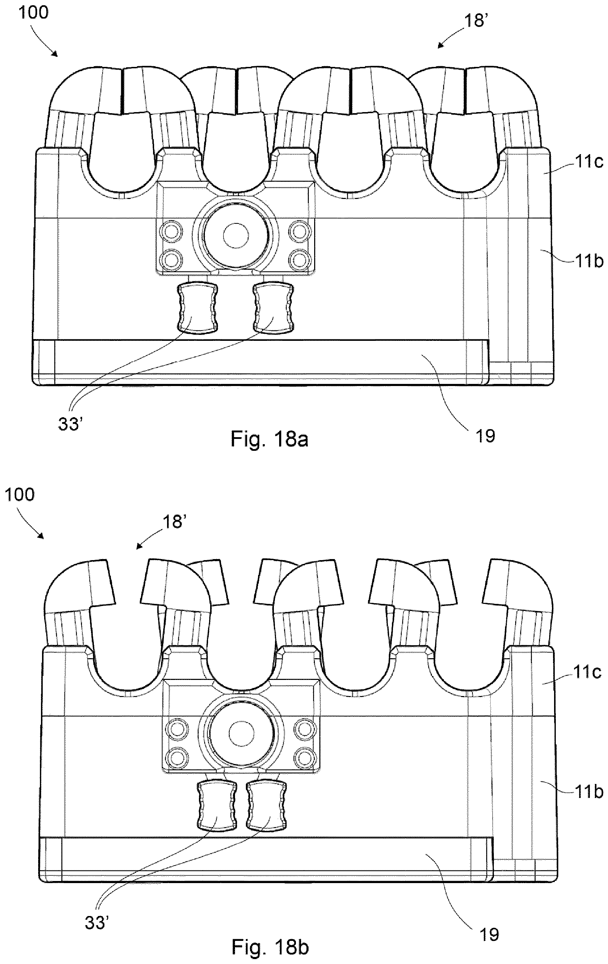

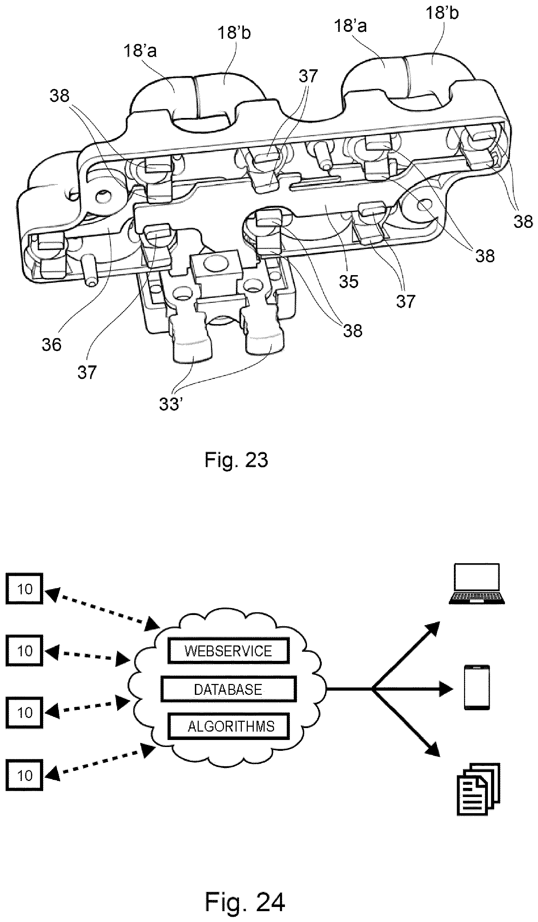

Figures 18a and 18b illustrate the two closing and opening end positions of the end pairs (18'a, 18'b) of the one or more rigid sensors, respectively. Said end pairs (18'a, 18'b) are actuated by means of two push-buttons (33') which, when joined together, open the end pairs (18'a, 18'b). Figure 23 shows a bottom perspective view of the interior of this second embodiment of the connection, sensing and measurement device of the invention (100), showing mechanical means that allow the opening and closing of the end pairs (18'a, 18'b) of the sensor (18'), in this case three sensors (18'). Two different lever elements (35, 36) are provided, both of wich displace at the same time the respective guides (37) of each end (18'a, 18'b). That is, a first lever element (35) simultaneously displaces the lower parts (37) of each left end (18'a) of the sensors while a second lever element (36) simultaneously displaces all the lower parts (38) of each right end of the sensors (18'b). The two lever elements (35, 36) have crimps to securely fix them to the lower parts (37 and 38). They also have lower extensions for a firm connection the pushbuttons (33').

Figure 24 shows a possible system of a group of devices (10 or 100) wirelessly connected and communicated with a server, such that they send processed output data to the server or receive data from this server. Said server, which may be cloud based, may comprise a database that receives the processed output data transmitted from one or more devices (10), algorithms and a webservice. Such database data may be viewed by a user via a computer, a mobile application, or printed, among other ways.

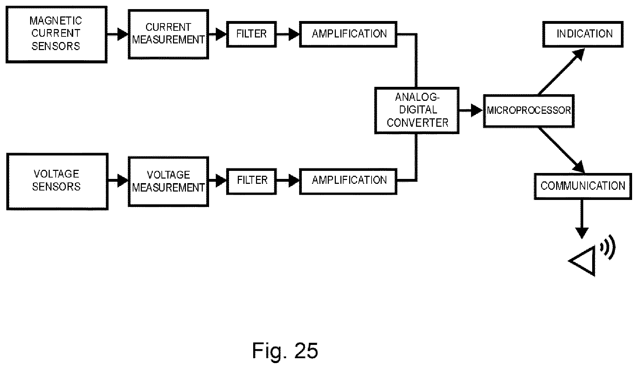

Figure 25 depicts a schematic block diagram of the various constituent elements of the connection, sensing and measurement device (10, 100) of the invention. The one or more closed-core current sensors (18) are responsible for measuring the current. The current measurement is then adapted by means of a filtering module and an amplification module. The signals are then sent to an analog-to-digital converter and then to a central microprocessor. On the other hand, the one or more connecting elements (16, 17) are responsible for measuring the grid voltage. The voltage measurement is then adjusted by means of a filtering module and another amplification module. The appropriate voltage signals are then sent to the analog-to-digital converter and then to the central microprocessor. The central microprocessor is responsible for processing at least the appropriate current and/or voltage signals and sends them to the indication module or to the wireless communication module. The indicator module sends the indication signals to the light indicators and the wireless communication module sends the processed signals to one or more external devices (not shown in Figure 25).

Although reference has been made to a specific embodiment of the invention, it is clear to a person skilled in the art that the device (10, 100) described is susceptible to numerous variations and modifications, without departing from the scope of protection defined by the attached claims.

## Claims

1. Connection, sensing and measurement device (10, 100), of the type that is electrically connectable to one or more of the screws, connecting terminals or clamps of an electrical grid switching device (13), wherein the switching device is an on-off switch, a magnetothermal switch, a differential switch, a transformer or an overvoltage protector, and wherein the connection, sensing and measurement device (10) comprises:
- a casing (11),
- one or more connection elements (16) extending outwardly of said housing (11) in a connection direction "Z", wherein each of the one or more connection elements (16) comprises a metallic or magnetic end (17) configured to be electrically removably connected to a respective screw, or connecting terminal, or clamp (25), or to any metallic point of attachment or connection of the wiring of the electrical grid switching device (13), so that through the one or more connecting elements (16), the connection, sensing and measurement device (10) can collect the voltage signal(s) from the electrical grid or inject them into the electrical grid; and
**characterised in that** it further comprises:
- one or more closed-core current sensors (18), configured to:
(a) sense the magnetic field present on a grid line and/or sense the effects of the injected signals, and/or
(b) inject the current signals circulating through the poles of the switching device (13),
wherein each of the one or more closed-core current sensors (18) comprises a loop with its two ends (18a, 18b) protruding from the housing (11) in the connection direction "Z", and
wherein said one or more end pairs (18a, 18b) of the loop can take two different positions:
i) a first installation position of the connection, sensing and measurement device (10) in the switchgear device, wherein the one or more pairs of sensor ends (18a, 18b) are open a certain space, so that when moving the connection, sensing and measurement device (10) in the connection direction "Z" said certain space between ends is greater than the diameter of a respective electrical cable previously installed in the switchgear device that runs in a vertical direction "Y" to pass through, and
ii) a second working position, wherein each pair of ends (18a, 18b) of the one or more closed-core current sensors (18) is closed or partially closed relative to each other forming a closed or partially closed space within the loop to house within it the respective electrical cable (31) of the switchgear device; and further comprising
- mechanical means for opening and closing the one or more end pairs (18a, 18b) of the one or more closed-core current sensors, driving the one or more end pairs (18a, 18b) from the second closed position to the first open position, and vice versa.

2. Connection, sensing and measurement device (10), according to claim 1, **characterized in that** the one or more connecting elements (16) are of the "plug&play" type and extend outwards in a vertical connection direction "Z", wherein each connecting element (16) is provided for a different pole of the switching device (13) with a respective magnetic end (17) configured to at the same time be fastened and electrically connected removably without any mechanical connection or wiring to a respective screw, or connecting terminal, or clamp (25), or to any metallic point of fixing or connection of the wiring of the switching device (13).

3. Connection, sensing and measurement device (100), according to claim 1, **characterized in that** the one or more connecting elements (16) extend outwards in a vertical connection direction "Y", wherein each connecting element comprises for a different pole of the switching device (13) a respective metal end (17') configured to be electrically removably connected to a metal point of attachment or connection of the wiring of the switching device (13) and wherein each metal end (17') is tightened by a respective screw.

4. Connection, sensing and measurement device (10) according to any one of claims 1, 2 or 3, **characterized in that** the one or more closed-core current sensors (18) are of the flexible type.

5. Connection, sensing and measurement device (10) according to any one of claims 1, 2 or 3, **characterized in that** the one or more closed-core current sensors (18) are of the rigid type.

6. Connection, sensing and measurement device (10) according to claim 1, **characterized in that** for single-phase power systems the connection, sensing and measurement device (10) has a closed-core sensor, and for three-phase power systems it has three closed-core current sensors.

7. Connection, sensing and measurement device (10) according to claim 4, **characterized in that** in the first working position one end (18a, 18b) of each closed-core current sensor (18) is touching the other end or crosses the other end.

8. Connection, sensing and measurement device (10) according to claim 4, **characterized in that** the mechanical means configured to open and close one or more pairs of ends (18a, 18b) of the flexible closed-core current sensors (18) from the first position to the second position comprise a portion (33) movable by the user in the connection direction "Z" and in the two senses which is guided to move all the groups of two ends at the same time.

9. Connection, sensing and measurement device (10) according to claim 8, **characterized in that** the movable portion (33) is formed by a side portion (33b) and a front portion (33a) integrally joined to each other, and wherein the front portion (33a) is provided with a hole (33c) for each tip configured so that a tip can pass through it, and in said front portion (33a) comprises guide elements (33e) with a curved profile for each tip.

10. Connection, sensing and measurement device (10) according to claim 9, **characterized in that** the side portion (33b) of the movable portion (33) comprises guide grooves (33d) for upper stops (43) provided in the housing (11) where the longitudinal guides (33d) extend along the direction of the "Z" axis.

11. Connection, sensing and measurement device (10) according to claim 9, **characterized in that** the housing (11) comprises guides (34) for the lateral guiding of the portion (33) in the "Z" direction.

12. Connection, sensing and measurement device (10), according to claim 2, **characterized in that** the one or more magnetic connecting elements (16) extend in a connecting direction "Z" from a front support plate (19) which is solidly attached to the housing (11) and wherein the front support plate (19) has a surface for handling and positioning and removal by the user of the connection, sensing and measurement device (10) in the switching device (13).

13. Connection, sensing and measurement device (10) according to any one of the preceding claims, wherein inside the housing (11) additional sensing means are incorporated for measuring parameters or signals other than voltage and current, which are chosen from one or more of the following: temperature, humidity, vibration and/or acceleration sensors, presence/movement/proximity, GPS, and/or lighting.

14. Connection, sensing and measurement device (10) according to claim 1, **characterized in that** it can additionally comprise inside the connection system (10) means for processing said parameters or signals captured and/or injected of current and/or voltage and/or other parameters wherein the processed parameters are one or more of the following: Hz, PF, KvarC, KVA, kW, kWh, KvarLh and/or LvarCh; and/or means for transmitting said parameters or signals measured or processed by the processing means to an external data management and/or storage device; and/or means for displaying or indicating the sensed, injected and/or processed parameters such as a digital screen (20), so that the user can view the values of said parameters in a preferential place of the connection system itself.

15. System, **characterized in that** it comprises:
- one or more connection, sensing and measurement devices (10) defined in any one of the preceding claims that send processed output data to one or more servers, and
- one or more servers, each comprising a database that receives the processed output data transmitted from one or more connection, sensing and measurement devices (10),
wherein the one or more connection, sensing and measurement devices (10) and the one or more servers are wirelessly connected and communicated.

16. A method for operating data processed by the device (10, 100) defined in anyone of the claims 1 to 14, comprising the following steps:
- electrically connecting the one or more connection, sensing and measurement devices (10, 100) in respective switching devices (13);
- registering a permitted user for the one or more connection, sensing and measurement devices (10, 100) on a web platform;
- the one or more connection, sensing and measurement devices (10, 100) sensing at least the voltage signal(s) of the electrical grid and the magnetic field present in a line of the grid,
- generating inside the one or more connection, sensing and measurement devices (10, 100) processed signals of at least the grid voltage signal (s) and the grid current signal (s);
- wirelessly sending the processed signals to one or more remote or local servers, each server comprising a database receiving and storing the processed signals transmitted from the one or more connection, sensing and measurement devices (10, 100); and
- viewing the processed signals stored in the database(s) by the permitted user in an loS or Android mobile application or in a computer.

## Patentansprüche

1. Verbindungs-, Erfassungs- und Messeinrichtung (10, 100) des Typs, der mit einer oder mehreren der Schrauben, Verbindungsanschlüssen oder Klemmen einer elektrischen Netzschaltvorrichtung (13) elektrisch verbindbar ist, wobei die Schaltvorrichtung ein Ein-Aus-Schalter, ein magnetothermischer Schalter, ein Differentialschalter, ein Transformator oder ein Überspannungsschutz ist und wobei die Verbindungs-, Erfassungs- und Messeinrichtung (10) umfasst:
- ein Gehäuse (11),
- ein oder mehrere Verbindungselemente (16), die sich von dem Gehäuse (11) in einer Verbindungsrichtung "Z" nach außen erstrecken, wobei jedes des einen oder der mehreren Verbindungselemente (16) ein metallisches oder magnetisches Ende (17) umfasst, das konfiguriert ist, elektrisch lösbar mit einer entsprechenden/einem entsprechendem Schraube oder Verbindungsanschluss oder Klemme (25) verbunden zu sein, oder mit einem beliebigen metallischen Befestigungs- oder Verbindungspunkt der Verdrahtung der elektrischen Netzschaltvorrichtung (13) elektrisch lösbar verbunden zu sein, so dass die Verbindungs-, Erfassungs- und Messeinrichtung (10) über das eine oder die mehreren Verbindungselemente (16) das/die SpannungssignalE aus dem elektrischen Netz erfassen oder in das elektrische Netz einspeisen kann; und
**dadurch gekennzeichnet, dass** sie ferner umfasst:
- einen oder mehrere Stromsensoren (18) mit geschlossenem Kern, die konfiguriert sind, um:
(a) das auf einer Netzleitung vorhandene Magnetfeld zu erfassen und/oder die Auswirkungen der eingespeisten Signale zu erfassen, und/oder
(b) die Stromsignale einzuspeisen, die durch die Pole der Schaltvorrichtung (13) zirkulieren,
wobei jeder von dem ein oder den mehreren Stromsensoren (18) mit geschlossenem Kern eine Schleife umfasst, deren beide Enden (18a, 18b) in Verbindungsrichtung "Z" aus dem Gehäuse (11) herausragen, und
wobei das eine oder die mehreren Paare von Enden (18a, 18b) der Schleife zwei verschiedene Positionen einnehmen kann/können:
i) eine erste Installationsposition der Verbindungs-, Erfassungs- und Messeinrichtung (10) in der Schaltanlage, bei der das eine oder die mehreren Paare von Sensorenden (18a, 18b) um einen bestimmten Raum offen sind, so dass beim Bewegen der Verbindungs-, Erfassungs- und Messeinrichtung (10) in der Verbindungsrichtung "Z" der bestimmte Raum zwischen den Enden größer als der Durchmesser eines entsprechenden elektrischen Kabels ist, das zuvor in der Schaltanlage installiert wurde und in einer vertikalen Richtung "Y" verläuft, um hindurchzugehen, und
ii) eine zweite Arbeitsposition, bei der jedes Paar von Enden (18a, 18b) des einen oder der mehreren Stromsensoren (18) mit geschlossenem Kern relativ zueinander geschlossen ist oder teilweise geschlossen ist, wobei ein geschlossener oder teilweise geschlossener Raum innerhalb der Schleife gebildet wird, um darin das jeweilige elektrische Kabel (31) der Schaltanlage aufzunehmen; und ferner umfassend
- mechanische Mittel zum Öffnen und Schließen des einen oder der mehreren Paare von Enden (18a, 18b) des einen oder der mehreren Stromsensoren mit geschlossenem Kern, die das eine oder die mehreren Paare von Enden (18a, 18b) von der zweiten geschlossenen Position in die erste offene Position und umgekehrt bringen.

2. Verbindungs-, Erfassungs- und Messeinrichtung (10) nach Anspruch 1, **dadurch gekennzeichnet, dass** das eine oder die mehreren Verbindungselemente (16) vom "plug&play"-Typ sind und sich in einer vertikalen Verbindungsrichtung "Z" nach außen erstrecken, wobei jedes Verbindungselement (16) für einen anderen Pol der Schaltvorrichtung (13) mit einem jeweiligen magnetischen Ende (17) versehen ist, das konfiguriert ist, gleichzeitig ohne jegliche mechanische Verbindung oder Verdrahtung an einer jeweiligen/einem jeweiligem Schraube oder Verbindungsanschluss oder Klemme (25) oder an einem beliebigen metallischen Befestigungs- oder Verbindungspunkt der Verdrahtung der Schaltvorrichtung (13) befestigt und elektrisch lösbar verbunden zu sein.

3. Verbindungs-, Erfassungs- und Messeinrichtung (100) nach Anspruch 1, **dadurch gekennzeichnet, dass** sich das eine oder die mehreren Verbindungselemente (16) in einer vertikalen Verbindungsrichtung "Y" nach außen erstrecken, wobei jedes Verbindungselement für einen anderen Pol der Schaltvorrichtung (13) ein jeweiliges metallisches Ende (17') umfasst, das konfiguriert ist, elektrisch lösbar mit einem metallischen Befestigungs- oder Verbindungspunkt der Verdrahtung der Schaltvorrichtung (13) verbunden zu sein, und wobei jedes metallische Ende (17') durch eine jeweilige Schraube festgezogen ist.

4. Verbindungs-, Erfassungs- und Messeinrichtung (10) nach einem der Ansprüche 1, 2 oder 3, **dadurch gekennzeichnet, dass** der eine oder die mehreren Stromsensoren (18) mit geschlossenem Kern vom flexiblen Typ sind.

5. Verbindungs-, Erfassungs- und Messeinrichtung (10) nach einem der Ansprüche 1, 2 oder 3, **dadurch gekennzeichnet, dass** der eine oder die mehreren Stromsensoren (18) mit geschlossenem Kern vom starren Typ sind.

6. Verbindungs-, Erfassungs- und Messeinrichtung (10) nach Anspruch 1, **dadurch gekennzeichnet, dass** die Verbindungs-, Erfassungs- und Messeinrichtung (10) für einphasige Stromsysteme einen Stromsensor mit geschlossenem Kern und für dreiphasige Stromsysteme drei Stromsensoren mit geschlossenem Kern aufweist.

7. Verbindungs-, Erfassungs- und Messeinrichtung (10) nach Anspruch 4, **dadurch gekennzeichnet, dass** in der ersten Arbeitsposition ein Ende (18a, 18b) jedes Stromsensors mit geschlossenem Kern (18) das andere Ende berührt oder kreuzt.

8. Verbindungs-, Erfassungs- und Messeinrichtung (10) nach Anspruch 4, **dadurch gekennzeichnet, dass** die mechanischen Mittel, die konfiguriert sind, ein oder mehrere Paare von Enden (18a, 18b) der flexiblen Stromsensoren (18) mit geschlossenem Kern von der ersten Position in die zweite Position zu öffnen und zu schließen, einen von dem Benutzer in der Verbindungsrichtung "Z" und in den beiden Richtungen bewegbaren Abschnitt (33) umfassen, der geführt wird, um alle Gruppen von zwei Enden gleichzeitig zu bewegen.

9. Verbindungs-, Erfassungs- und Messeinrichtung (10) nach Anspruch 8, **dadurch gekennzeichnet, dass** der bewegliche Abschnitt (33) durch einen Seitenabschnitt (33b) und einen vorderen Abschnitt (33a) gebildet wird, die integral miteinander verbunden sind, und wobei der vordere Abschnitt (33a) mit einem Loch (33c) für jede Spitze versehen ist, das so konfiguriert ist, dass eine Spitze hindurchtreten kann, und in dem vorderen Abschnitt (33a) Führungselemente (33e) mit einem gekrümmten Profil für jede Spitze umfasst.

10. Verbindungs-, Erfassungs- und Messeinrichtung (10) nach Anspruch 9, **dadurch gekennzeichnet, dass** der Seitenabschnitt (33b) des beweglichen Abschnitts (33) Führungsnuten (33d) für obere Anschläge (43) umfasst, die im Gehäuse (11) vorgesehen sind, wo sich die Längsführungen (33d) entlang der Richtung der "Z"-Achse erstrecken.

11. Verbindungs-, Erfassungs- und Messeinrichtung (10) nach Anspruch 9, **dadurch gekennzeichnet, dass** das Gehäuse (11) Führungen (34) für die seitliche Führung des Abschnitts (33) in der "Z"-Richtung aufweist.

12. Verbindungs-, Erfassungs- und Messeinrichtung (10) nach Anspruch 2, **dadurch gekennzeichnet, dass** sich das eine oder die mehreren magnetischen Verbindungselemente (16) in einer Verbindungsrichtung "Z" von einer vorderen Trägerplatte (19) erstrecken, die fest mit dem Gehäuse (11) verbunden ist und wobei die vordere Trägerplatte (19) eine Fläche zur Handhabung und Positionierung und Entnahme der Verbindungs-, Erfassungs- und Messeinrichtung (10) in der Schaltvorrichtung (13) durch den Benutzer aufweist.

13. Verbindungs-, Erfassungs- und Messeinrichtung (10) nach einem der vorhergehenden Ansprüche, wobei im Inneren des Gehäuses (11) zusätzliche Erfassungsmittel zum Messen von anderen Parametern oder Signalen als Spannung und Strom eingebaut sind, die aus einem oder mehreren der folgenden ausgewählt sind: Temperatur-, Feuchtigkeits-, Vibrations- und/oder Beschleunigungssensoren, Anwesenheits-/Bewegungs-/Annäherungssensoren, GPS- und/oder Lichtsensoren.

14. Verbindungs-, Erfassungs- und Messeinrichtung (10) nach Anspruch 1, **dadurch gekennzeichnet, dass** sie zusätzlich im Inneren des Verbindungssystems (10) Mittel zur Verarbeitung der genannten Parameter oder Signale, die von Strom und/oder Spannung und/oder anderen Parametern erfasst und/oder eingespeist werden, wobei die verarbeiteten Parameter einer oder mehrere der folgenden sind: Hz, PF, KvarC, KVA, kW, kWh, KvarLh und/oder LvarCh; und/oder Mittel zum Übertragen der von den Verarbeitungsmitteln gemessenen oder verarbeiteten Parameter oder Signale an eine externe Datenverwaltungs- und/oder Datenspeichervorrichtung; und/oder Mittel zum Darstellen oder Anzeigen der erfassten, eingespeisten und/oder verarbeiteten Parameter, wie z.B. ein digitaler Bildschirm (20), so dass der Benutzer die Werte der Parameter an einem bevorzugten Ort des Verbindungssystems selbst sehen kann, umfassen kann.

15. System, **dadurch gekennzeichnet, dass** es umfasst:
- eine oder mehrere der in einem der vorhergehenden Ansprüche definierten Verbindungs-, Erfassungs- und Messeinrichtungen (10), die verarbeitete Ausgangsdaten an einen oder mehrere Server senden, und
- einen oder mehrere Server, von denen jeder eine Datenbank umfasst, die die verarbeiteten Ausgangsdaten empfängt, die von einem oder mehreren Verbindungs-, Erfassungs- und Messeinrichtungen (10) übertragen werden,
wobei das eine oder die mehreren Verbindungs-, Erfassungs- und Messeinrichtungen (10) und der eine oder die mehreren Server drahtlos verbunden sind und miteinander kommunizieren.

16. Verfahren zum Betrieb von Daten, die von der nach einem der Ansprüche 1 bis 14 definierten Vorrichtung (10, 100) verarbeitet werden, umfassend die folgenden Schritte:
- elektrisches Verbinden der einen oder mehreren Verbindungs-, Erfassungs- und Messeinrichtungen (10, 100) in jeweiligen Schaltanlagen (13);
- Registrieren eines zugelassenen Benutzers für die eine oder mehrere Verbindungs- , Erfassungs- und Messeinrichtungen (10, 100) auf einer Webplattform;
- Erfassen durch die eine oder mehrere Verbindungs-, Erfassungs- und Messeinrichtungen (10, 100) zumindest des/der Spannungssignal(e) des elektrischen Netzes und des in einer Leitung des Netzes vorhandenen Magnetfelds,
- Erzeugen von verarbeiteten Signalen zumindest des Netzspannungssignals (der Netzspannungssignale) und des Netzstromsignals (der Netzstromsignale) innerhalb der einen oder mehreren Verbindungs-, Erfassungs- und Messeinrichtungen (10, 100);
- drahtloses Senden der verarbeiteten Signale an einen oder mehrere entfernte oder lokale Server, wobei jeder Server eine Datenbank umfasst, die die verarbeiteten Signale empfängt und speichert, die von der einen oder den mehreren Verbindungs-, Erfassungs- und Messeinrichtungen (10, 100) übertragen werden; und
- Betrachten der verarbeiteten und in der/den Datenbank(en) gespeicherten Signale durch den berechtigten Benutzer in einer loS- oder Android-Mobilanwendung oder auf einem Computer.

## Revendications

1. Dispositif de connexion, de détection et de mesure (10, 100), du type pouvant être connecté électriquement à une ou plusieurs vis, bornes de connexion ou colliers d'un dispositif de commutation du réseau électrique (13), dans lequel le dispositif de commutation est un interrupteur marche-arrêt, un interrupteur magnétothermique, un interrupteur différentiel, un transformateur ou un protecteur de surtension, et dans lequel le dispositif de connexion, de détection et de mesure (10) comprend :
- un carter (11) ;
- un ou plusieurs éléments de connexion (16) s'étendant vers l'extérieur dudit boîtier (11) dans une direction de connexion « Z », dans lequel chacun des éléments de connexion (16) comprend une extrémité métallique ou magnétique (17) configurée pour être connectée électriquement et de manière amovible à une vis, à une borne de connexion ou à un collier (25) respectif, ou à tout point métallique de fixation ou de connexion du câblage du dispositif de commutation du réseau électrique (13), de sorte qu'à travers les éléments de connexion (16), le dispositif de connexion, de détection et de mesure (10) puisse collecter le(s) signal(aux) de tension du réseau électrique ou les injecter dans le réseau électrique ; et
**caractérisé en ce qu'**il comprend en outre :
- un ou plusieurs capteurs de courant à noyau fermé (18), configurés pour :
(a) détecter le champ magnétique présent sur une ligne de grille et/ou détecter les effets des signaux injectés, et/ou
(b) injecter les signaux de courant circulant à travers les pôles du dispositif de commutation (13),
dans lequel chacun des un ou plusieurs capteurs de courant à noyau fermé (18) comprend une boucle dont les deux extrémités (18a, 18b) dépassent du boîtier (11) dans la direction de connexion « Z », et
dans lequel une ou plusieurs paires d'extrémités (18a, 18b) de la boucle peuvent prendre deux positions différentes :
i) une première position d'installation du dispositif de connexion, de détection et de mesure (10) dans l'appareil de commutation, dans laquelle la ou les paires d'extrémités de capteurs (18a, 18b) sont ouvertes dans un certain espace, de sorte que lors du déplacement du dispositif de connexion, de détection et de mesure (10) dans la direction de connexion «Z», ledit espace entre les extrémités soit plus grand que le diamètre d'un câble électrique respectif précédemment installé dans l'appareil de commutation qui s'étend dans une direction verticale « Y » pour passer à travers, et
ii) une deuxième position de travail, dans laquelle chaque paire d'extrémités (18a, 18b) d'un ou de plusieurs capteurs de courant à noyau fermé (18) est fermée ou partiellement fermée l'une par rapport à l'autre, formant un espace fermé ou partiellement fermé à l'intérieur de la boucle pour y loger le câble électrique respectif (31) de l'appareil de commutation ; et comprenant en outre
- des moyens mécaniques pour ouvrir et fermer la ou les paires d'extrémités (18a, 18b) du ou des capteurs de courant à noyau fermé, en faisant passer la ou les paires d'extrémités (18a, 18b) de la deuxième position fermée à la première position ouverte, et inversement.

2. Dispositif de connexion, de détection et de mesure (10), selon la revendication 1, **caractérisé en ce que** les un ou plusieurs éléments de connexion (16) sont du type « plug&play » et s'étendent vers l'extérieur dans une direction de connexion verticale « Z », dans lequel chaque élément de connexion (16) est fourni pour un pôle différent du dispositif de commutation (13) avec une extrémité magnétique respective (17) configurée pour être à la fois fixée et connectée électriquement de manière amovible sans connexion mécanique ou câblage à une vis, une borne de connexion ou une pince (25) respective, ou à tout point métallique de fixation ou de connexion du câblage du dispositif de commutation (13).

3. Dispositif de connexion, de détection et de mesure (100), selon la revendication 1, **caractérisé en ce que** les un ou plusieurs éléments de connexion (16) s'étendent vers l'extérieur dans une direction de connexion verticale « Y », dans lequel chaque élément de connexion comprend, pour un pôle différent du dispositif de commutation (13), une extrémité métallique respective (17') configurée pour être connectée électriquement de manière amovible à un point métallique de fixation ou de connexion du câblage du dispositif de commutation (13) et dans lequel chaque extrémité métallique (17') est serrée par une vis respective.

4. Dispositif de connexion, de détection et de mesure (10) selon l'une quelconque des revendications 1, 2 ou 3, **caractérisé en ce que** le ou les capteurs de courant à noyau fermé (18) sont de type flexible.

5. Dispositif de connexion, de détection et de mesure (10) selon l'une quelconque des revendications 1, 2 ou 3, **caractérisé en ce que** le ou les capteurs de courant à noyau fermé (18) sont de type rigide.

6. Dispositif de connexion, de détection et de mesure (10) selon la revendication 1, **caractérisé en ce que**, pour les systèmes électriques monophasés, le dispositif de connexion, de détection et de mesure (10) comporte un capteur de courant à noyau fermé, et pour les systèmes électriques triphasés, il comporte trois capteurs de courant à noyau fermé.

7. Dispositif de connexion, de détection et de mesure (10) selon la revendication 4, **caractérisé en ce que**, dans la première position de travail, une extrémité (18a, 18b) de chaque capteur de courant à noyau fermé (18) touche l'autre extrémité ou la croise.

8. Dispositif de connexion, de détection et de mesure (10) selon la revendication 4, **caractérisé en ce que** les moyens mécaniques configurés pour ouvrir et fermer une ou plusieurs paires d'extrémités (18a, 18b) des capteurs de courant flexibles à noyau fermé (18) de la première position à la seconde position comprennent une partie (33) mobile par l'utilisateur dans la direction de connexion « Z » et dans les deux sens qui est guidée pour déplacer tous les groupes de deux extrémités en même temps.

9. Dispositif de connexion, de détection et de mesure (10) selon la revendication 8, **caractérisé en ce que** la partie mobile (33) est formée d'une partie latérale (33b) et d'une partie avant (33a) jointes d'un seul tenant l'une à l'autre, et dans lequel la partie avant (33a) est pourvue d'un trou (33c) pour chaque pointe configuré de manière à ce qu'une pointe puisse le traverser, et **en ce que** ladite partie avant (33a) comprend des éléments de guidage (33e) avec un profil incurvé pour chaque pointe.

10. Dispositif de connexion, de détection et de mesure (10) selon la revendication 9, **caractérisé en ce que** la partie latérale (33b) de la partie mobile (33) comprend des rainures de guidage (33d) pour les butées supérieures (43) ménagées dans le boîtier (11) dans lequel les guides longitudinaux (33d) s'étendent le long de la direction de l'axe « Z ».

11. Dispositif de connexion, de détection et de mesure (10) selon la revendication 9, **caractérisé en ce que** le boîtier (11) comprend des guides (34) pour le guidage latéral de la partie (33) dans la direction « Z ».

12. Dispositif de connexion, de détection et de mesure (10), selon la revendication 2, **caractérisé en ce qu'**un ou plusieurs éléments de connexion magnétiques (16) s'étendent dans une direction de connexion « Z » à partir d'une plaque de support avant (19) qui est solidement fixée au boîtier (11) et dans lequel la plaque de support avant (19) présente une surface pour la manipulation et le positionnement et le retrait par l'utilisateur du dispositif de connexion, de détection et de mesure (10) dans l'appareil de commutation (13).

13. Dispositif de connexion, de détection et de mesure (10) selon l'une quelconque des revendications précédentes, dans lequel des moyens de détection supplémentaires sont incorporés à l'intérieur du boîtier (11) pour mesurer des paramètres ou des signaux autres que la tension et le courant, choisis parmi un ou plusieurs des éléments suivants : capteurs de température, d'humidité, de vibration et/ou d'accélération, de présence/mouvement/proximité, GPS, et/ou d'éclairage.

14. Dispositif de connexion, de détection et de mesure (10) selon la revendication 1, **caractérisé en ce qu'**il peut comprendre en outre, à l'intérieur du système de connexion (10), des moyens de traitement desdits paramètres ou signaux capturés et/ou injectés de courant et/ou de tension et/ou d'autres paramètres, les paramètres traités étant un ou plusieurs des suivants : Hz, PF, KvarC, KVA, kW, kWh, KvarLh et/ou LvarCh ; et/ou des moyens de transmission desdits paramètres ou signaux mesurés ou traités par les moyens de traitement vers un dispositif externe de gestion et/ou de stockage des données ; et/ou des moyens d'affichage ou d'indication des paramètres détectés, injectés et/ou traités, tels qu'un écran numérique (20), afin que l'utilisateur puisse visualiser les valeurs de ces paramètres à un endroit préférentiel du système de connexion lui-même.

15. Système, **caractérisé en ce qu'**il comprend :
- un ou plusieurs dispositifs de connexion, de détection et de mesure (10) définis dans l'une quelconque des revendications précédentes qui envoient des données de sortie traitées à un ou plusieurs serveurs, et
- un ou plusieurs serveurs comprenant chacun une base de données qui reçoit les données de sortie traitées transmises par un ou plusieurs dispositifs de connexion, de détection et de mesure (10),
dans lequel le ou les dispositifs de connexion, de détection et de mesure (10) et le ou les serveurs sont connectés et communiqués sans fil.

16. Procédé d'exploitation des données traitées par le dispositif (10, 100) défini selon l'une quelconque des revendications 1 à 14, comprenant les étapes suivantes :
- la connexion électrique du ou des dispositifs de connexion, de détection et de mesure (10, 100) dans les dispositifs de commutation respectifs (13) ;
- l'enregistrement d'un utilisateur autorisé pour un ou plusieurs dispositifs de connexion, de détection et de mesure (10, 100) sur une plateforme web ;
- le ou les dispositifs de connexion, de détection et de mesure (10, 100) détectant au moins le(s) signal(aux) de tension du réseau électrique et le champ magnétique présent dans une ligne du réseau,
- la génération, à l'intérieur d'un ou de plusieurs dispositifs de connexion, de détection et de mesure (10, 100), des signaux traités d'au moins le(s) signal(aux) de tension du réseau et le(s) signal(aux) de courant du réseau ;
- l'envoi sans fil des signaux traités à un ou plusieurs serveurs locaux ou distants, chaque serveur comprenant une base de données recevant et stockant les signaux traités transmis par un ou plusieurs dispositifs de connexion, de détection et de mesure (10, 100) ; et
- la visualisation des signaux traités stockés dans la (les) base(s) de données par l'utilisateur autorisé dans une application mobile loS ou Android ou dans un ordinateur.
